(19) Europäisches Patentamt
European Patent Office
Office européen des brevets

(11) **EP 4 718 723 A1**

(12) **EUROPEAN PATENT APPLICATION**

(43) Date of publication:
**01.04.2026  Bulletin 2026/14**

(51) International Patent Classification (IPC):
***H03K 17/082*** (2006.01)       ***H03K 17/08*** (2006.01)

(21) Application number: **25306490.1**

(22) Date of filing: **17.09.2025**

(52) Cooperative Patent Classification (CPC):
**H03K 17/0822;** H03K 2017/0806; H03K 2217/0027;
H03K 2217/0063

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **27.09.2024  IT 202400021488**

(71) Applicant: **STMicroelectronics International N.V.**
**1228 Plan-les-Ouates, Genève (CH)**

(72) Inventors:
• **LETOR, Romeo**
  **95030 MASCALUCIA (CT) (IT)**

• **RANDAZZO, Vincenzo**
  **95033 Biancavilla (IT)**
• **TRECARICHI, Calogero Andrea**
  **93012 Gela (CL) (IT)**
• **MARZO, Alberto**
  **95014 Giarre (CT) (IT)**
• **BARTHEL, Jochen**
  **83135 Schechen (DE)**
• **DUPUY, Philippe**
  **80807 MÜNCHEN (DE)**

(74) Representative: **Buzzi, Notaro & Antonielli d'Oulx
S.p.A.
Corso Vittorio Emanuele II, 6
10123 Torino (IT)**

(54) **A PROTECTION CIRCUIT, CORRESPONDING SYSTEM AND METHOD**

(57)    A circuit (50; 50'; 55) for protection of a power transistor (14), in particular a power MOSFET, coupled at a first electrode to a battery power supply (15) and to another electrode to a load (18), and driven at a driving electrode by a driver circuit (13), wherein
said circuit for protection (50; 50'; 55) comprises Safe Operating Area monitoring circuitry (60; 60'; 70) configured to control the transistor (14) operation with respect to its Safe Operating Area (PMS), which receives as input at least a current value ($I_{sense}$) proportional to a current (ID) flowing through said power transistor (14),
said Safe Operating Area monitoring circuitry (60; 60'; 70) being configured to control the operation of the power transistor (14) with respect to said Safe Operating Area (PMS) as a function of transistor thermal behaviour information (PMS, SSI; 100) and said at least a current value proportional to a current (ID) flowing through said power transistor (14) to control the value of a junction temperature (Tj) of the transistor (14), outputting an output signal (OUT; OUT1) which value controls on and off states of said driver circuit (13) by a switch (23) driving of the power transistor to obtain a given behaviour in time of the junction temperature (Tj) of the transistor (14) within said Safe Operation Area.

Fig. 9

EP 4 718 723 A1

**Description**

Technical field

The description relates to protection circuits.

One or more embodiments may apply to the protection of a power transistor while keeping available the full current/time area limited by the Safe Operation Area of the Power transistor.

Technological background

For power semiconductor devices (such as BJT, MOSFET, thyristor or IGBT), the safe operating area (SOA) is defined as the voltage and current conditions over which the device can be expected to operate without selfdamage.

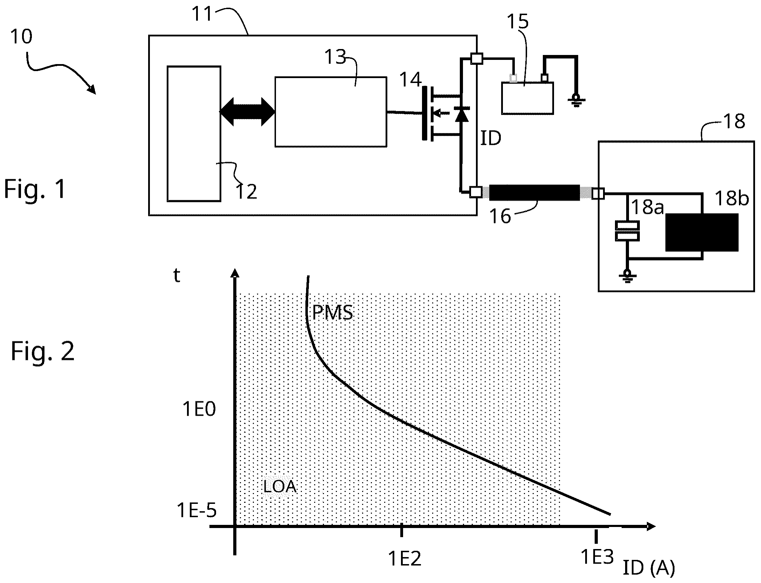

A typical application example is the automotive power distribution module (as better detailed with reference to Figure 1 below) where the load requires a current/time operating area (described with reference to figure 2) extended to very high current range that it is several time higher than nominal DC operation.

By example, when charging a Bulk capacitance, the current time area is close to the Power transistor SOA boundary. Operation inside such area need to be allowed without false overload detections.

Also, other loads can have huge transient current for relatively long time, and they may require to operate inside the load operating area (as discussed below with reference to Figure 2).

Thus, in figure 1 is shown a system 10 for supplying power to a load 18 in which a power distribution module 11 comprises a microcontroller unit or MCU 12 which exchanges signals with a gate driver 13 to command its operation, driving a power transistor, e.g., MOSFET, 14, which two electrodes, namely drain and source being a MOSFET, are coupled respectively to a battery 15, coupled at the other end to ground, and on the source, in the example to the load 18 through a cable 16, the load 18 being schematized through a load capacitor 18a, e.g. in the 100 mF range, and a utility 18b.

In figure 2 it is represented a diagram showing the current ID flowing through the transistor 14. In the following, with the current ID flowing through the transistor 14 is meant the current which flows between the two output electrodes, drain and source for the MOSFET. Transistor current ID in figure 2 is, in ampere, on the horizontal axis of the diagram and the time t on the vertical axis, this being one of the representations to evaluate safe operation regions and curve for a transistor. In figure it is shown thus a safety boundary curve PMS, identifying the limit or boundary of the Safety Operating Area or SOA of the transistor 14, i.e. power MOS, which is the area underlying the boundary curve PMS, i.e. current time values which should not be exceeded. This curve PMS is valid when the drain source voltage VDS of the MOSFET is equal to the on resistance Ron by the current, i.e. when the transistor 14 works in saturation. Also in the figure is indicated a load operating area LOA, which indicates where the transistor 14 operates.

As mentioned, when charging a bulk capacitance, the current time load operating area LOA is close to the SOA of the power transistor 14, i.e. the boundary curve PMS. Operation inside such area need to be allowed without false overload detections.

Also, other loads can have huge transient current for relatively long time, and they may require to operate inside the load operating area LOA shown in figure 2.

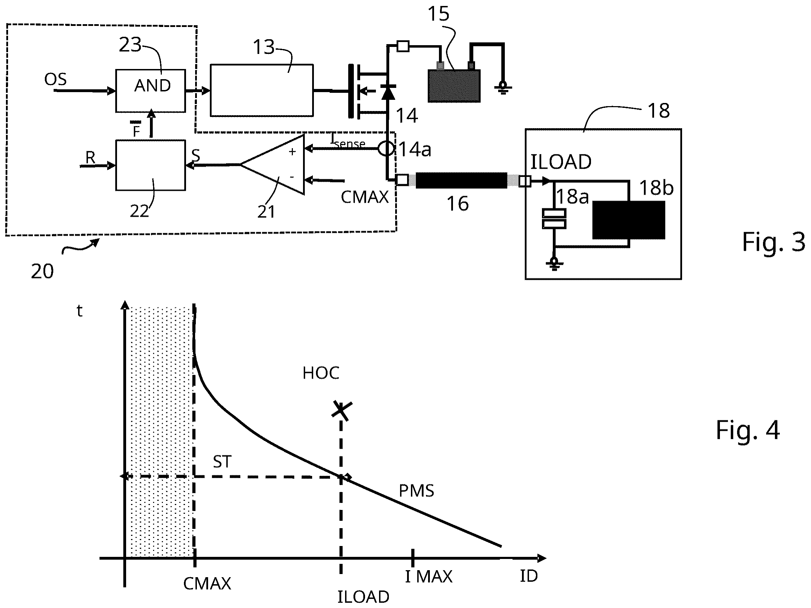

In figure 3 is shown a system 20 for protection of a power transistor, with maximum current control, in which it is performed the protection of the power transistor 14 against overload. An output of a comparator 21 rises when the transistor current ID in the power transistor 14, sensed as sense current $I_{sense}$, sensed on the output node, i.e. source node, by a sense circuit 14a, e.g., an amperometric sensor (of any type known to those of skill in the art), reaches a value higher than a maximum current value CMAX, brought at its other input. A latch 22, in particular of the Set Reset type, is coupled to the output of such comparator 21 through its set input S. This condition, value of sense current $I_{sense}$ greater than the value maximum current CMAX, latches off, i.e., sets off the operation, the power transistor 14 by triggering the latch 22, and the power transistor 14 remains off until the latch 22 is reset (signal on reset input R, e.g. by an external logic not shown). This is obtained by coupling the output of the latch F (which in particular the negated output of the latch 22) as input to an AND gate 23, which receives also an ON/OFF signal OS, e.g. from a logic or the MCU 12, and feeds the gate driver 13.

The maximum current value CMAX needs to be settled at a value lower than a Maximum DC current, i.e. current IMAX, capability of the power transistor 14 as shown in figure 4, showing a current time diagram like in figure 2. Therefore, the allowed load operating area LOA is restricted. Referring to the diagram of figure 4, the value of Maximum DC current IMAX cannot be settled to a higher current value since a hypothetical overload condition HOC with transistor current ID lower than the Maximum DC current IMAX would not be detected, thus the power transistor 14 could work outside its safe operating area. A safe time ST and a load current ILOAD, i.e. current flowing in the load are the values determining the hypothetical overload condition HOC. The hypothetical overload condition HOC may destroy the Power Transistor 14 since the time duration of the hypothetical overload condition HOC is higher than the safe time ST for a current equal to the load current ILOAD.

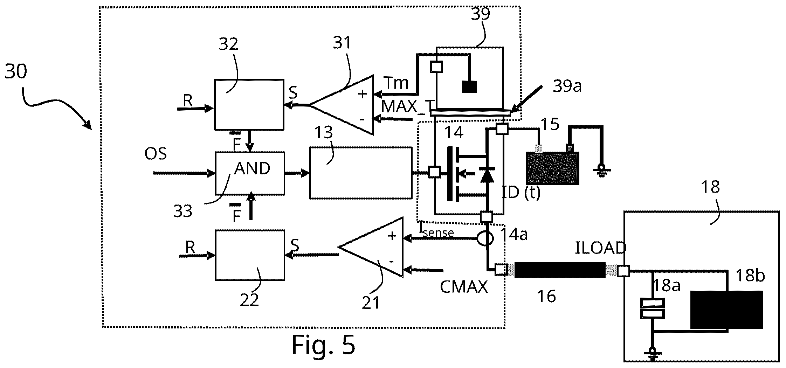

In figure 5 it is shown a system 30 for protection of a power transistor, with a thermal sensor external to the power transistor 14, which includes both maximum current control, similar to circuit arrangement 20, and a thermal sensor 39 thermally coupled with a tab 39a, a drain tab in the example, i.e. a metal tab coupled to the drain of the power transistor 14. The same comparator 21 output rises when the current ID in the power transistor 14, as sense current $I_{sense}$ sensed on the output node, i.e. source node, by a sense circuit 14a, reaches a value higher than a maximum current CMAX at its other input. Also here the current latch 22 is coupled to the output of the comparator 21 through is set input S.

In this case it is performed coupling the output F (in particular negated) of the latch 22 as input to an AND gate 33, with three inputs, which receives also the ON/OFF signal OS and the output of a second temperature latch 32 and feeds its output to the gate driver 13.

The second temperature latch 32 receives the output of a temperature comparator 31 which at its input receives the output signal, i.e., temperature measurement value, Tm, of a temperature sensor 39, e.g. NTC (Negative Temperature Coefficient, and a reference maximum temperature value signal MAX_T.

Therefore, the power transistor 14 can be latched off either by the current latch 22 if the load current ILOAD in the power transistor 14 is higher than maximum current CMAX or if the thermal sensor 39 reaches (and signals) a maximum temperature value MAX T.

Therefore, the power transistor 14 can be latched off either by the current latch 22 if the sense current $I_{sense}$, proportional to the current ID in the transistor 14, is higher than current CMAX or if the thermal sensor 39 reaches (and signals) a maximum temperature value MAX T.

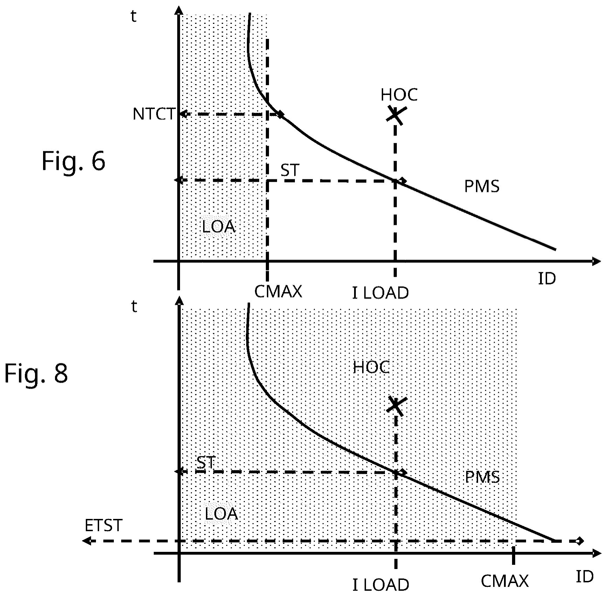

Since the heat propagation time from the power transistor 14 junction to the tab 39a of the power transistor 14 is in the 100 ms range (response time NTC), the temperature sensor 39 is not able to protect the power transistor 14 against fast transients with timing below 100ms. For this reason, the value of maximum current CMAX need to be set to a value compatible with the timing of the temperature sensor 39 that is quite close to the maximum DC current IMAX. Therefore, for the power transistor 14 the allowed load operating area LOA in figure 6, showing a current time diagram like in figure 2, is still restricted much below the real available operating area.

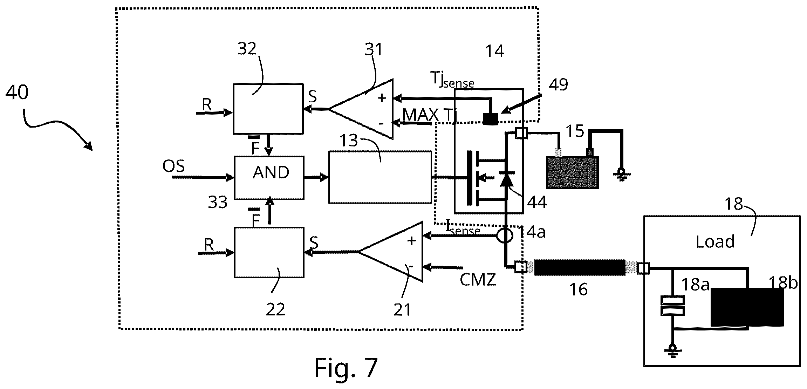

In figure 7 it is shown a solution of a system 40 with a thermal sensor 49, supplying a sensed junction temperature $Tj_{sense}$ to an amplifier 31, embedded in a power transistor 44, in particular a MOSFET; structure.

The block diagram of figure 7 describes this solution used in combination with a maximum current control strategy like in figure 5, i.e., with the current latch 22 and temperature latch 32. This solution is typically used inside smart power devices where the power transistor 14 is integrated together with the gate driver 13. Thanks to optimized thermal coupling with the junction of the power transistor 14, the thermal sensor 49 allows to monitor with high precision very fast thermal transient caused by high current flowing in the power transistor 14 (faster response time ETST). This solution allows to protect the power transistor 14 and at the same time allow to match the load operating area LOA with a safe operating area SOA of the power transistor 14 as shown in figure 8, showing a current time diagram like in figure 2, 4 and 6. With ETST is indicated the embedded thermal sensor 49 response time.

## Object and summary

An object of one or more embodiments is to contribute in providing improved solutions along the lines discussed in the foregoing.

According to one or more embodiments, such an object can be achieved by means of a protection circuit having the features set forth in the claims that follow.

One or more embodiments may relate to a corresponding system for supplying electrical power to a load for use in the automotive sector.

One or more embodiments may relate to a corresponding method.

The claims are an integral part of the disclosure of the invention as provided herein.

One or more embodiments may find use in automotive power distribution applications.

One or more embodiments may provide one or more of the following advantages:

avoiding having an integrated thermal sensor inside the Power MOSFET;
integration in a Power-MOS gate driver module with the aim to protect the transistor against excessive fast and slow thermal events due to overload conditions.
ensuring safe operation of the Power-MOS and at the same time making available the full current time operation capability of the Power-MOS itself.

## Brief description of the figures

One or more embodiments will now be described, by way of example only, with reference to the annexed figures, wherein:

- Figures 1 to 8 have been described in the foregoing,
- Figure 9 is a block diagram of a protection circuit according to embodiments;
- Figure 10 is a block diagram of a protection circuit according to further embodiments
- Figure 11 is an implementation of a module of the protection circuit of figure 9
- Figure 12 is a current time diagram pertaining the protection circuit of figure 9;
- Figure 13 include three superposed diagrams (A), (B), (C), with a common time scale exemplifying the possible behavior of a circuit according to embodiments of the present description;
- Figure 14 is a block diagram of a protection circuit according to further embodiments;
- Figure 15 is a schematic representation of a thermal model of the transistor of a transistor protected by the protection circuit according to embodiments;
- Figure 16 is a current time diagram pertaining the protection circuit of figure 14;
- Figure 17 is a block representation of a circuit configured to calculate a junction temperature of the transistor on the basis of the model of figure 15;
- Figure 18 and 19 represent schematically variant embodiments with respect figure 15;
- Figure 20 represent by a block diagram a system incorporating a circuit according to embodiments of the present description.

Detailed description of examples of embodiments

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment. Moreover, particular conformations, structures, or characteristics may be combined in any adequate way in one or more embodiments. The references used herein are provided merely for convenience and hence do not define the extent of protection or the scope of the embodiments.

In brief, the solution here described performs a control of the operation of the power transistor, limiting the transistor operating area in the current versus time ID(t) diagram by means of a Safe Operating Area (SOA) monitoring circuitry.

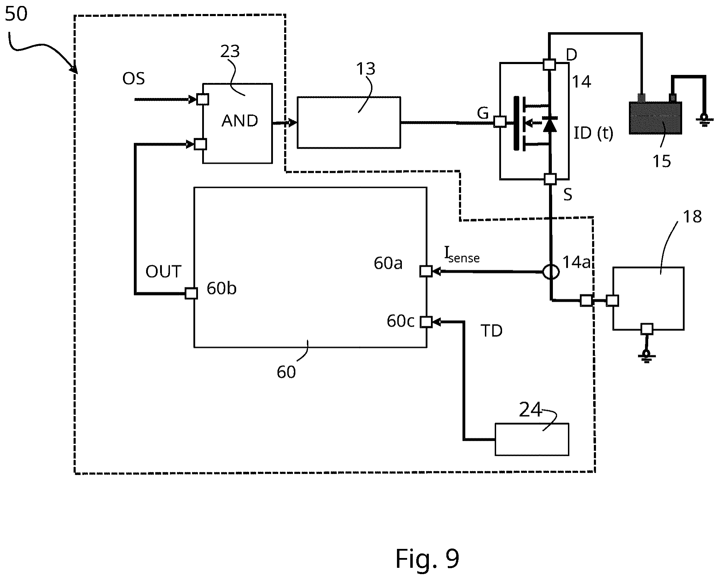

In an embodiment, described with reference to figure 9, the Safe Operating Area (SOA) monitoring circuitry operates on the basis only of the measured current ID(t) flowing in the power transistor 14, i.e. the current at its drain electrode.

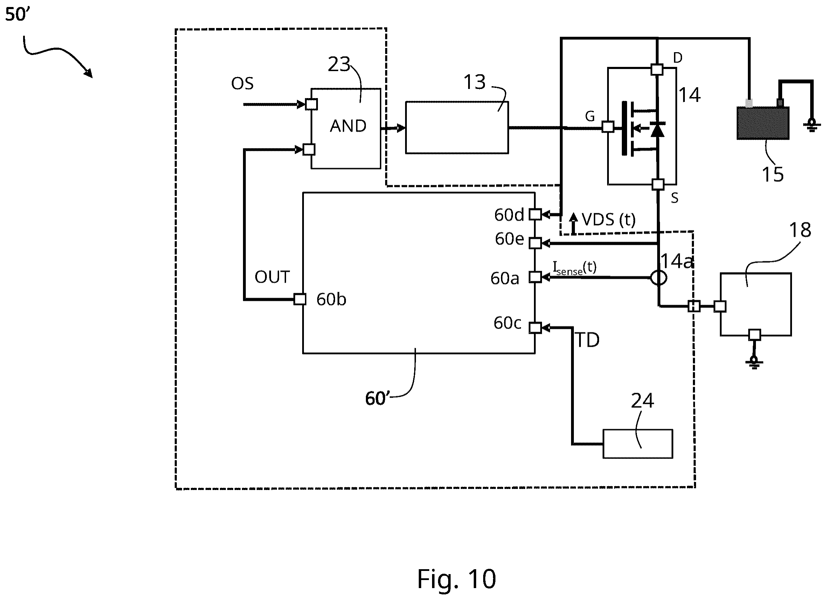

In an embodiment, described with reference to figure 10, the Safe Operating Area (SOA) monitoring circuitry operates on the basis of both current ID(t) and voltage drop behavior VDS (t) across the power transistor, i.e., drain voltage source. Voltage drop behavior (VDS) may be useful for additional verifications since the safe operation can also be a function of the voltage drop. By way of example, the transistor may desaturate and operate in linear mode where the safe operating conditions can change.

The Safe Operating Area (SOA) monitoring circuitry in figures 9 and 10 may use also transistor data available from the power transistor specifications, i.e., datasheet, or obtainable by dedicated characterization. Such data can comprise by way of example: the on drain source resistance RDSON (or RON) of the power MOSFET embodying the transistor, thermal data such as thermal impedance, diagram of maximum current versus time, and other data in particular useful to establish the thermal behavior of the transistor.

Such data are defined on the base of the SOA monitoring circuitry strategy. One option can be to control in direct way the transistor current ID(t) area. Another option may be to use variables to simulate in real time the transistor operating condition as for example the instant junction temperature.

The output signal of the SOA monitoring circuitry monitor output can be used to switch off the Power Transistor as soon as it is evaluated to be outside the Safe operating area.

A system 50 for protection of a power transistor 14, i.e. a MOSFET, is shown in figure 9, which according the solution here described, is configured to perform a limitation of the transistor operating area current versus time ID(t) by means of a Safe Operating Area (SOA) monitoring circuitry 60.

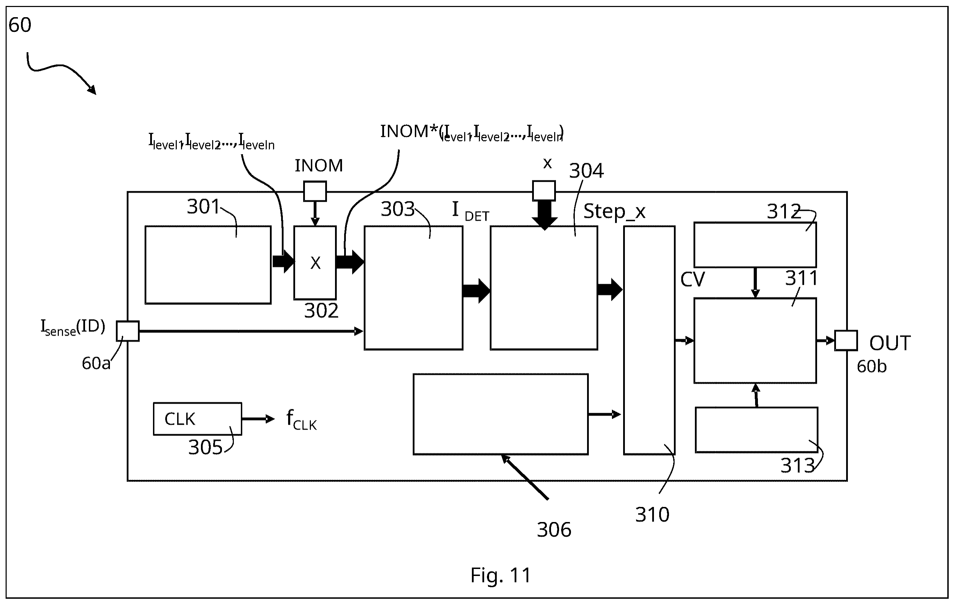

The system 50 for protection of a power transistor 14 basically presents the same circuital arrangement of the system 20 of figure 3, however in place of the latch 22 and comparator 21 the SOA monitoring circuitry 60 is provided receiving the sense current $I_{sense}$, at an input node 60a, which measures the current ID(t), in particular taken by a current sensor 14a between the source electrode of the power transistor 14 and load 18. The SOA monitoring circuitry 60 receives also transistor data TD, at a node 60c. The operation of the SOA monitoring circuitry 60, operating with transistor current ID and transistor data TD as inputs is described below with reference to figures 11-13. The SOA monitoring circuitry 60 outputs an output signal OUT at an output node 60b, to the latch 22.

In figure 10 a variant embodiment of the architecture of figure 9, comprising an embodiment 50' of the system for protection of a power transistor 14, is described where also a voltage drop behavior VDS (t) across the power transistor 14 is received by the SOA monitor. Besides receiving also drain and source voltage at input pins (60c, 60d) of the SOA monitoring circuitry 60', for internal measuring (not shown), the architecture is the same of figure 9, which uses instead the SOA monitoring circuitry 60 operating only with the sense current $I_{sense}$, which measures the current ID(t) (received at node 60a), in particular taken by a current sensor 14a, in other words circuitry 60' receives sense current $I_{sense}$ and transistor data TD, as well. Voltage (VDS) can be required for additional verifications since Power Transistor 14 safe operation can also be a function of the voltage drop. As mentioned, for instance the power transistor 14 may desaturate and operate in linear mode where the safe operating conditions can change.

Power Transistor SOA monitoring circuitry 60 and 60' in figure 9 and 10 respectively use then transistor data TD available from a module 24 representing specifications, e.g. data sheet or other type of data repository, of the power transistor 14, or obtainable by dedicated characterization. Of course, module 24 may be represented by a data storage or a link to an external source supplying the data. This in general may apply also to other blocks supplying values, such as counter maximum value Counter Max o hysteresis value Hys, and others, as explained below. Such data TD can comprise by example: on drain source resistance RDSON of a Power MOSFET, Thermal data such as thermal impedance, diagram of maximum current versus time, etc....

Such transistor data TD are defined on the basis of the SOA monitoring circuitry 60 or 60' strategy.

One option may be to control in a direct way the transistor current ID(t) area. Another option may be to use variables to simulate in real time the transistor working condition as for example the instant junction temperature.

The SOA monitoring circuitry 60 or 60' output signal (OUT) can be used to switch off the power transistor 14 as soon as working operation is evaluated to be outside the Safe operating area.

Safe operation of the power transistor 14 in real time as described in figure 9 may be implemented for instance by the implementation of the monitoring circuitry 60 described in more detail with reference to figure 11.

Here, using the power transistor 14 current ID as an input, in particular its measure, sense current $I_{sense}$, a counter up/down 310 is incremented (or decremented) with the following criterion, based on a stepped curve SSI, shown in figure 11, which approximates the boundary curve PMS. With x is indicate a time coordinate of the stepped curve, i.e., a step function, and Level (x) is the transistor current ID (or proportional current $I_{sense}$) current level at that time coordinate x:

when the transistor 14 current ID, namely proportional current $I_{sense}$, is included between two levels (Level (X), Level (X-1)), Level (x) being the current level at time X, and Level X-1 the current level at the previous time coordinate X-1, the timer, i.e. counter 310, is incremented with a determined time step STEP_x so that a counter 310 output value CV reaches a maximum value Counter_MAX when the time duration of the transistor 14 current ID level corresponds to the timing value, i.e., time coordinate x. The Maximum value Counter_MAX is a fixed constant, supplied to an evaluation block 311, and therefore the time step STEP_x is calculated in block 304 by solving the equation: Step_X = Counter MAX/( x* FCLK), i.e., the maximum value Counter MAX of the counter divided by the product of the time coordinate x by the clock frequency FCLK. With 305 is indicate a clock available in the architecture hosting the protection circuit 50 or in the circuit 50 itself, which provides the clock frequency FCLK;

if the transistor 14 current ID is below a low current level ILOW, as detected by a current level detection block 303, the counter 310 is decreased, by a module 306, with a constant step until its counter value CV reaches zero. The low current level ILOW can be defined as the maximum DC current capability of the Power transistor 14 and can be also defined as ILOW = INOM, INOM being a nominal current which is supplied. Thus, normalized current levels are supplied from block 301, normalized with respect to the nominal current INOM, which corresponds to value of the lowest level of current among the current levels used for detection. These normalized current levels are multiplied by the nominal current value INOM, i.e. denormalized, and supplied to the current level detection 303 for comparison with the transistor 14 current ID. In variant embodiments, equivalently the current ID may be divided by the nominal current INOM and then compared to normalized current levels. It is equivalent. We can multiply the normalized values by INOM and compare them to ID or divide ID/INOM and compare with normalized values. See Fig 11_review.

the power transistor 14 is latched by block 311, i.e. the output OUT of block 311, e.g., SOA monitoring circuitry 60, has a value which latches transistor 14, i.e. in the example commanding the AND 23 with the on/off signal OS, until the output value CV of the counter 310 reaches the maximum value counter MAX, at which time the signal OUT changes value to one which determines the latch off of the transistor 14, e.g., OUT changes logical value thus changing the output of AND 23, and it can be reset ON when the value of the counter 310 is lower than the maximum value Counter MAX minus an hysteresis value Hys, also supplied to block 311 for evaluation.

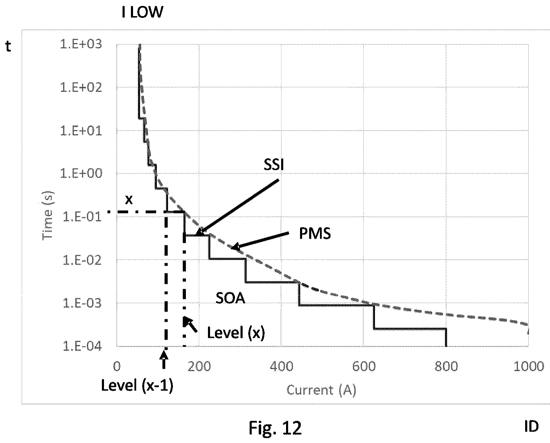

The implementation of circuit 60 for protection of a power transistor of figure 11 allows the power transistor 14 to work inside the current time area limited by a stepped safe curve SSI that approximates the safe current time operating area, i.e. SOA, of the Power transistor 14, as shown in Figure 12. This safe operating area SOA can be supplied by the transistor manufacturer or as an option the safe current time (It) curve can be calculated. In general, this curve is an I^2t or I2t curve (current squared through time) that represents the maximum current that causes the junction temperature Tj of the power transistor 14, i.e., the MOSFET, to reach a maximum value.

As an option the input data to determine the stepped curve SSI can be only two input values, nominal current INOM and Timing x, and they can be defined as follows:

- the input of the nominal current value INOM of the circuit 60 in figure 11 can be used to define an array of current levels (output of multiplier block 302) obtained as INOM * [ $I_{level1}$, $I_{leve12}$, ... $I_{leveln}$] where [$I_{level1}$, $I_{level2}$, ..., $I_{leveln}$] is an array 301 of current levels normalized to $I_{level1}$, in particular the lowest value ILOW, the generic INOM* $I_{leveli}$ corresponding to the generic Level (x) current level indicated above. In block 303 the current levels INOM * [ $I_{level1}$, $I_{level2}$, ... $I_{leveln}$] are compared to the transistor 14 current ID measure (more precisely proportional current $I_{sense}$) to detect the detected current level $I_{DET}$ to which ID or $I_{sense}$ belong, which is then supplied to block 304, which receives also the timing X, which performs the selection of the counter 310 step Step_x as function of the current level detected in block 303;
- the input called timing X, of time coordinate x, of the circuit 60 in figure 11 can be used to define an array of timing obtained as x*[t1, t2, ... tn] where [t1, t2,...tn] is array of timings, i.e. time instants, normalized to instant t1.

As an alternative option the stepped curve SSI can be defined as an input to the SOA monitoring circuitry 60 with two arrays pertaining timing and current levels representing the steps.

When the power transistor 14 is switched off or when the current ID in the power transistor 14 is below a defined value (ILOW), the counter 310 is decreased with a fixed step. The power transistor 14 can be turned on again when CV < Counter MAX - Hys. This function allows to restart the power transistor 14 with a defined duty cycle so that the power dissipation is limited below a certain value and the junction temperature Tj is limited below a maximum value.

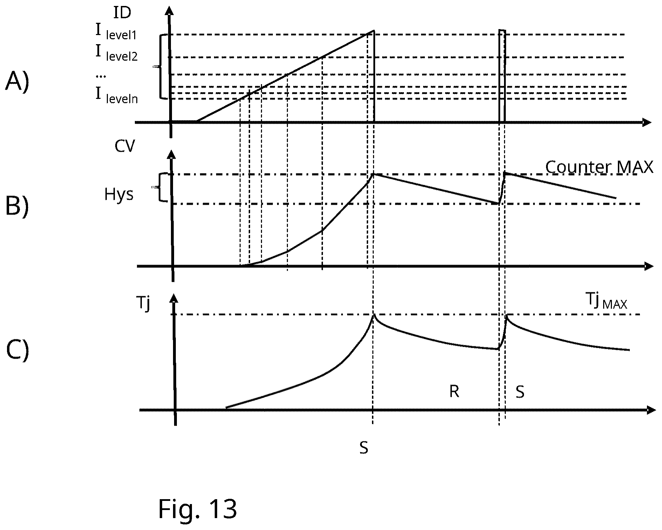

The diagrams as a function of time, representing the transistor current ID (A), counter value CV (B) and junction temperature Tj (C) as a function of time, of figure 13 show the behavior of the counter 310 when by example the transistor current ID has a linear ramp shape. From figure 13 it is possible to observe that, with the counter step Step_X changing, the counter 310 speed changes when the transistor ID current increases from one current level to another according to the counter step Step_X selected. In fact, figure 13 (B) shows that the counter output CV can be considered as a representation of the junction temperature Tj in the power transistor 14, as they show substantially a similar behaviour in time. Also, when the power transistor 14 is switched off the counter 310 decreases its counter output value CV in line with the junction temperature Tj, so it is possible to define a hysteresis value Hys for an auto restart strategy while controlling a duty cycle and the maximum junction temperature variation. S e R indicates the signal at the inputs of latch 22, set latch and reset latch, i.e. unlatch, of the power transistor on the basis of the output signal OUT of the circuit 60. $Tj_{MAX}$ indicated a maximum of junction temperature Tj, which is selected by choosing the value of the maximum value Counter Max.

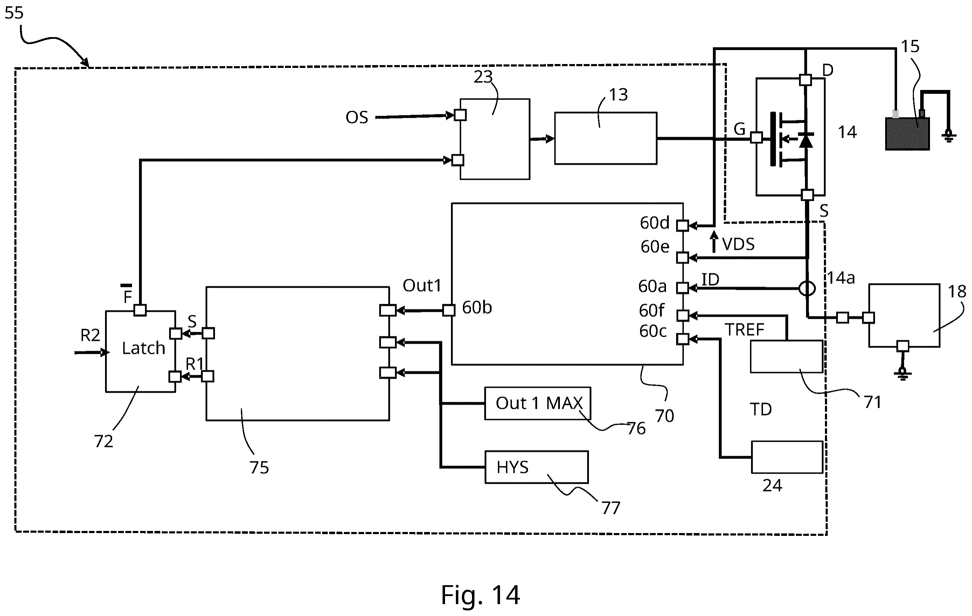

In figure 14 it is shown a block diagram describing a further embodiment 55 of a system for protection of a Power transistor 14, while keeping available load operating area well-matched with the safe operating area SOA of the Power MOSFET 14.

The protection of the Power transistor 14 is implemented via a SOA monitoring circuitry 70 configured for real time control of the junction temperature Tj without any temperature sensor embedded in the power transistor 14 itself.

Block 70 may operate like the block 60 previously described in figure 11, i.e., with the up down counter 310 operating the transistor current ID measure, without block 311, which is replaced by block 75, in other word block 70 plus 75 may be equivalent in function to block 60.

An output Out1 of block 70 in figure 14 is represented by a value correlated or equal to the junction temperature Tj of the power transistor 14, correlation being for instance as such between CV as Out1 and Tj shown in figure 13 . The Power transistor 14 operates inside its safe operating area SOA, i.e., the latch 72 is set, i.e., is asserted by a logic circuit 75 configured to assert the set signal S when the value, e.g. counter value CV, at the output Out1 is below a maximum value out1_MAX and, optionally, if the variation of the value of the output out1 is below a defined Hysteresis value Hys (from block 77, analogous to block 313 in figure 11), to assert reset R1 so the power transistor 14 can switch on again ensuring a junction temperature Tj variation below maximum temperature variation for transistor reliability (Set S if out1 j > out1 MAX; Reset R1 if out1 < out1 - Hys).

The value of the output out1 may however preferably be calculated in real time using state variables of the power transistor 14 such as drain current (ID) measured by a current sensor 72, drain source voltage VDS measured on the power transistor 14 terminals, i.e. the module 70 receives the voltage at the drain and source of the power transistor 14 and comprise a circuit configure to measure the drain source voltage VDS.

In embodiments, the transistor data TD from transistor data module 24 such as power transistor 14 electrical characteristics can be used to calculate the value of the output Out1, i.e., a value correlated or equal to junction temperature Tj. By way of example, if the power transistor 14 is always operating in saturation mode, it is VDS = RDSon*ID, RDSon being on the ON resistance of the transistor 14 obtainable from transistor data TD, then a power dissipation Pd can be calculated as Pd = RDSon*ID^2. Transistor data TD can comprise also a definition of safe operating conditions in terms of maximum current versus time and voltage or also thermal data can be used to calculate Junction temperature Tj.

In further embodiments, thermal data or thermal modeling can be used for the calculation of value out1 performed in block 70, i.e., a value correlated or equal to junction temperature Tj.

A specified safe operating area SOA of the power transistor 14 defined with a curve current time like in figure 3 can be used to calculate such value Out1 from block 70. Safe operating area SOA is defined in the Power Transistor data 14 sheet with a specification of ambient temperature Ta and maximum junction temperature $Tj_{MAX}$ condition.

A reference temperature TREF is also supplied to module 70, at node 60f, which can be either, the ambient temperature of the ambient 500 or the temperature in a known position outside the Power transistor 14. Also, a conventional temperature can be used as reference temperature TREF as, by way of example, a fixed maximum ambient temperature Ta.

In embodiments, thermal data or thermal modeling can be used for the calculation of the value out_1 of circuitry 70.

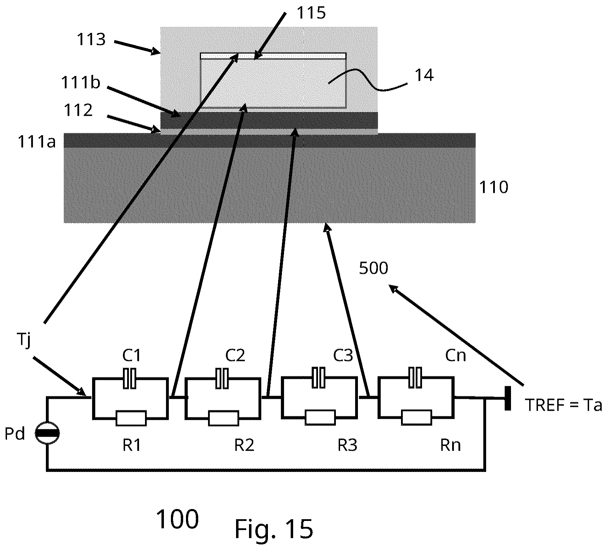

The thermal impedance ZTH(t) is a transfer function that can be expressed either with a ZTH (t) curve or with an equivalent thermal model expressed with an electrical equivalent circuit (as in figure 15). Therefore, it is possible to define the thermal impedance ZTH(t) in equation below

$$ZTH\,(t) = \sum_{i=1}^{n} ZTH_i(t) = \sum_{i=1}^{n} R_i\left(1 - e^{-t/R_i C_i}\right) \qquad (1)$$

as the pulse response of the thermal model 100 defined in figure 15. The thermal model 100 is represented by an equivalent electrical RC network, also known as lumped model or concentrated parameter model where each i-th RC cell $R_iC_i$, i.e. parallel resistance $R_i$ and capacitor $C_i$, is characterized by a time constant expressed by the resistance by capacity product, RC. By example, each RC cell $R_iC_i$ of the lumped model 100 can be explained with a correspondence to the physical elements of the power transistor 14 and its boundary environment. Arrows in figure 15 shows this correspondence to the interface, i.e. temperatures of the interfaces between the layers there indicated. This is a mere example as the lumped model is well known, depend on the specific modelling of the structure, and can be obtained for instance from the transistor data sheet, e.g., data TD.

In figure 15 is thus shown a thermal model 100 of a power device which can be used to simulate the thermal behaviour of the power transistor 14. There, on a PCB 110 are two frame layers 111a and 111b tied by a solder layer 112. On the upper frame layer 111b is a molding 113 encasing a power transistor 14, i.e. MOSFET. With 115 is indicated the junction. Below an equivalent thermal circuit comprises a series of RC cells with thermal resistance and thermal capacitance in parallel, R1C1 corresponding to power transistor 114, R2C2, corresponding to solder 112 and other subcircuits up to RnCn to corresponding other layers up to the PCB 115. Of course, different lumped models with different sets of layers associated to a different sequence of RC cells are possible, depending on the type of transistor and type of model. The dissipated power Pd determines an input temperature Ti in the series of RC cells, corresponding to the temperature Tj of the junction 115, while at the other end of the RC cell series the reference temperature TREF, e.g. ambient temperature Ta is applied.

This kind of modeling conventionally used for simple junction temperature simulation can be found usually inside the Power transistor 14 data sheet as mentioned and/or in alternative can be obtained by a dedicated thermal characterization. The number n of RC cells is not a fixed number since it can change depending on the required fitting precision between the thermal model and the real system behavior.

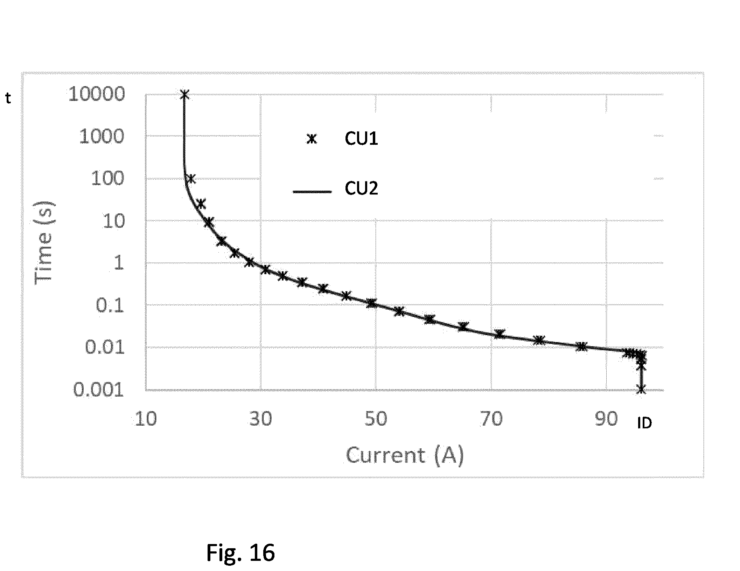

Thus, regarding an embodiment of block 70 of figure 14, with reference to the diagram current time of figure 16, SOA operation can be defined with an operating area current time that is the result of maximum junction temperature Ti (Tj). This may be compared to a smart power device that has an embedded thermal sensor to control safe operation by switching off with a thermal shut down, like in figure 7. The crosses in figure 16 indicate the embedded thermal sensor curve (e.g. like in figure 7) CU1, the continuous line indicated the boundary curve PMS limit of the SOA, CU2, calculated with the thermal model, as discussed here below. The diagram of Figure 16 shows that real current time operation of a power transistor controlled using embedded junction thermal sensor can be calculated using a thermal impedance ZTH(t), as per equation (1) above, and equation (2), shown in the following.

$$Current\,(time\ x) = \sqrt{\frac{MAX\ \Delta Tj}{ZTH\,(time\ x) * RON}} \quad (2)$$

i.e. current (time x), the current ID at time x, is the square root of the ratio of a maximum junction temperature difference $\Delta Tj$, i.e., the variation of junction temperature applying a given dissipated power Pd to the thermal impedance ZTH(t) at time x multiplicated by the on resistance RON (or RDSON). This is an approximation because it is considered the dissipated power Pd = RON*I2 = constant during the time interval time x. In reality the ON resistance RON increases with the junction temperature Tj, therefore RON*I2 is not constant. For safe calculation, the value of the ON resistance RON is set to a maximum value at the maximum junction temperature difference ΔTj. Equation 2 is solution of

$$MAX\,\Delta Tj\;=\;PD{*}ZTH\,(time\,x) = RON{*}current(time\,x)^2{*}ZTH(time\,x) \quad (3)$$

indicating that the maximum junction temperature difference ΔTj is obtained by the product of the dissipated power Pd by the thermal impedance ZTH at time x.

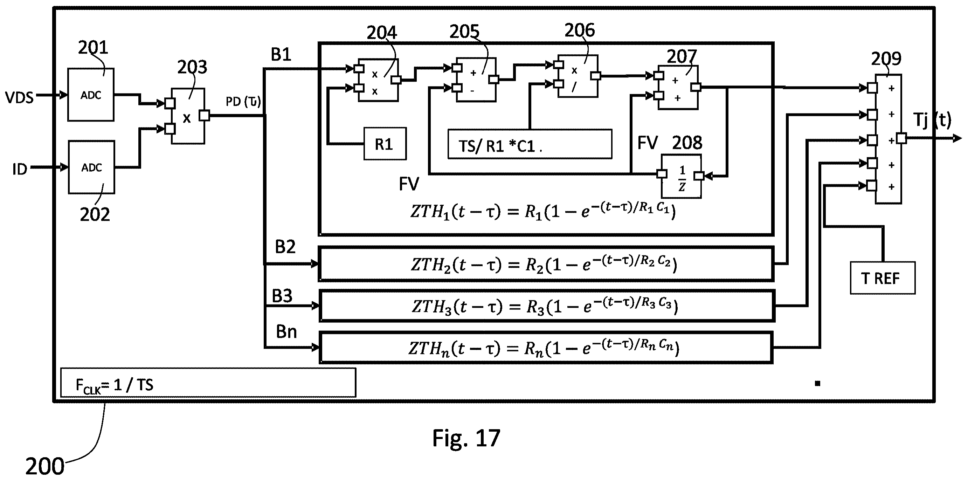

The simulation maximum junction temperature difference makes the integral of convolution between Pd and ZTH. This calculation is accurate since it can take in consideration dissipated power Pd variations versus junction temperature Tj and time. For example in he block diagram of figure 17 Pd = VDS*ID where VDS and ID are value in real time. In this case the variation of RON vs Tj is already included inside the measured drain source voltage VDS which represents the voltage drop on the Power Transistor 14. If only the transistor current ID is measured in real time, the calculation of power dissipation RON*I2 need to be compensated with a feedback of the junction temperature Tj.

The simulation of the circuit 100 in figure 15 allows to calculate the junction temperature *Tj(t)* at each instant in real time and this simulation can be implemented using the circuit shown in the block diagram of Figure 17.

The circuit 200 there shown implements the convolution operation

$$Tj\,(t) = T\,REF + (Pd * ZTH)\,(t) = T\,REF + \int Pd(\tau) * ZTH\,(t - \tau) * d\tau$$

between the power dissipation as a function of time *Pd(τ)* inside the power Transistor 14, as per equation (5)

$$Pd\,(\tau) = VDS\,(\tau) * ID(\tau) \quad (5)$$

and the thermal impedance *ZTH(t)* between Power transistor Junction and a physical reference, as per equation (6),

$$ZTH\,(t) = \sum_{i=1}^{n} ZTH_i(t) = \sum_{i=1}^{n} R_i\left(1 - e^{-t/R_i\,C_i}\right) \quad (6)$$

i.e., the terminal impedance n in time is equal to the sum of the products of each cell Ri resistance by the respective decay, e.g., curve, i.e. an exponential decay curve with $R_iC_i$ time constant.

Timing is controlled by a clock CLK which set the sampling time TS ($f_{CLK}$=1/TS) of the input variables (ID, VDSi). Sampling time TS is compatible with the variable transients and allows the output of the state machine Tj(T) to be a real time value. This circuit 200 may also require others auxiliary clocks at higher frequency for mathematical operation steps control.

As shown the circuit 200 may be implemented by a digital circuitry embedded in an integrated circuit. Alternatively, it can be implemented by firmware inside a micro controller or other processor-based device. Thus, more in detail, with reference to figure 17 the block schematics of figure 200 show an implementation with blocks representing modules configured to perform corresponding operations. In particular the drain source voltage VDS of the power transistor 14, i.e. MOSFET, and its current ID flowing from drain to source are brought as input to respective analog to digital converters 201 and 202 which outputs are brought as input to block 203 configured to perform the convolution according to the equation *Pd (τ) = VDS (τ) * ID(τ)*, thus outputting power dissipation *Pd (τ)*. The power dissipation *Pd(τ)* is brought in parallel to n branches B1...Bn each performing the calculation of the thermal impedance ZTH$_i$ relative to a respective i-th RC cell R$_i$C$_i$, ZTH$_i$, by the equation (6),

$$ZTH\,(t) = \sum_{i=1}^{n} ZTH_i(t) = \sum_{i=1}^{n} R_i\left(1 - e^{-t/R_i\,C_i}\right)$$

In the figure, an exemplary branch, in particular the first branch B1, is detailed, performing in a block 204 multiplication of the resistance R1 of the respective cell R1C1, with power dissipation *Pd(τ)*, then in a block 205 from its output is subtracted a feedback value FV, i.e., the output of the branch B1, obtaining an error value supplied to division a block 206 along with a value TS/R$_1$C$_1$, i.e. ratio of the sampling time TS, inverse of the clock frequency f$_{CLK}$, to the time constant of the given RC cell, in this case R$_1$C$_1$, respectively sent to the denominator input of a division block 206, The output of block 206 is supplied to a summation block 207 along with feedback value FV, which is obtained by feeding back through a delay block 208, i.e. 1/Z transfer function, an output of the block 207. Each output of each branch Bi is sent to a summation block 209, which also receives the reference temperature TREF, computing the junction temperature Tj(t) at each sampling period.

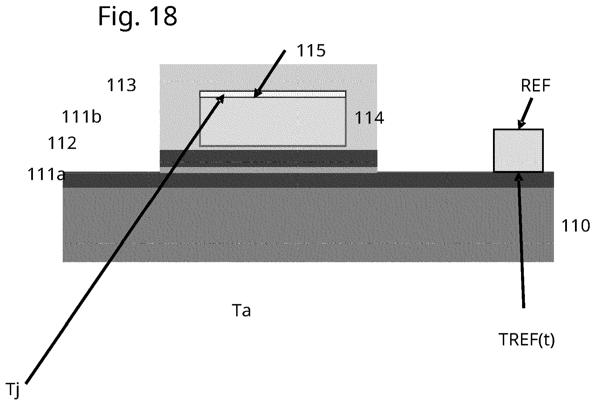

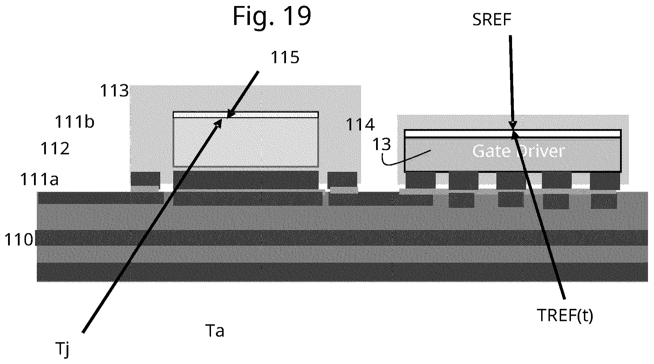

The physical thermal reference TREF can be the ambient temperature Ta, or optionally, it can be a point of the space outside the power transistor 14, with a known temperature, as shown in figure 18, where a reference element REF, e.g. a component, a metallization or any point to place a reference temperature sensor is shown. Figure 19 describes a possible implementation of the physical thermal reference TREF. It is a thermal sensor SREF embedded in the gate driver 13 integrated circuit, so the reference temperature TREF(t) in time can be a temperature value available in real time inside the integrated circuit and can be used to calculate the real time junction Tj temperature of the power transistor 14 upon a dedicated thermal modeling of the thermal impedance between the thermal sensor inside the integrated circuit and the junction 115 of the Power transistor 114.

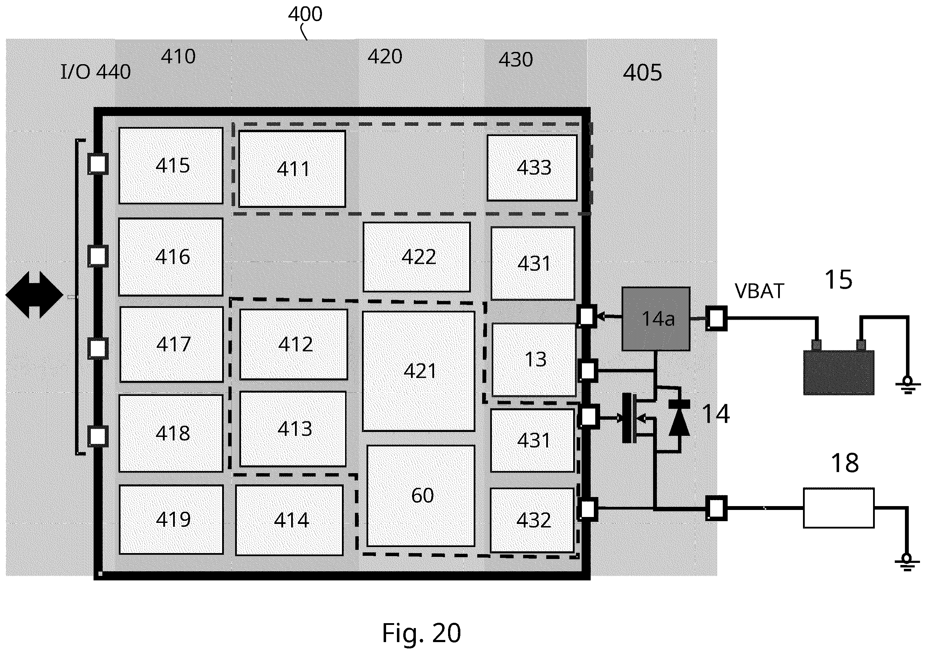

Figure 20 shows by a block diagram an implementation of circuit for protection in an example application of gate driver 13 for E-Fuse, i.t. MOSFET transistor 14, in automotive power distribution.

The architecture comprises a gate driver module 400 and an E-fuse portion 405, which comprises the MOSFET transistor 14, with the battery 18 supplying a battery voltage to the drain of the transistor 14 and a load 18 coupled to the output of the MOSFET transistor 14, i.e. its source, and also the current sensor 14a, which in this case is place on the coupling between the battery 18 and the drain of the MOSFET transistor 14, to sense the current ID flowing through the transistor 14.

The gate driver module 400 comprises a Gate Driver & Sensors group 430 of modules comprising the gate driver 13 driving the transistor 14, as well as other modules such as a standby switch 433, charge Pump 431, a VDS sense 431, which may correspond to the circuit sensing the VDS in figure 10, a module 432 for sensing the battery voltage VBAT and the output voltage on the source of the transistor 14 coupled to the load 18.

Then the gate driver module 400 comprises a group 420 of Power MOSFET which comprises the circuit for protection of the MOSFET transistor, for example 60, and other protection modules such as and Overcurrent and VDS Control module 421 and BEMF (Back ElectroMotive Force) Clamping 422.

Then the gate driver module 400 comprises a group of System & safety related functions modules 410 comprising a Parameter Setting module 415, a Monitoring module 411, a Diagnostic module 417, a Cable Protection module 412, a Self Test module 416, control modules 418, a capacity Pre charge module 413, a LIMP Home module 414 to manage reduced efficiency modes, Watch Dog modules 419.

Finally the gate driver module 400 comprises an input/output module 410 to interface with other modules, e.g. vehicle ASIL (Automobile Safety Integrity Level) modules or other vehicle ECUs, through communication links, e.g. CANbus or Ethernet.

Thus, summarizing, on basis of the above, it is here described a circuit, e.g. 50; 50'; 55, for protection of a power transistor, e.g. 14, in particular a power MOSFET, coupled at a first electrode to a battery power supply, e.g. 15, and to another electrode to a load, e.g. 18, and driven at a driving electrode by a driver circuit, e.g. 13,, wherein

said circuit for protection, e.g. 50; 50'; 55, comprises Safe Operating Area monitoring circuitry, e.g. 60; 60'; 70, configured to control the transistor, e.g. 14, operation with respect to its Safe Operating Area, e.g. PMS, which receives as input at least a current value, e.g. I$_{sense}$, proportional to a current, e.g. ID, flowing through said power transistor, e.g. 14,

said Safe Operating Area monitoring circuitry, e.g. 60; 60'; 70, being configured to control the operation of the power transistor, e.g. 14, with respect to said Safe Operating Area, e.g. PMS, as a function of transistor thermal behaviour information, e.g. PMS, SSI; 100, and said at least a current value proportional to a current, e.g. ID, flowing through said power transistor, e.g. 14, to control the value of a junction temperature, e.g. Tj, of the transistor, e.g. 14,, outputting an output signal, e.g. OUT; OUT1, which value controls on and off states of said driver circuit, e.g. 13, by a switch, e.g. 23, driving of the power transistor to obtain a given behaviour in time of the junction temperature, e.g. Tj, of the transistor, e.g. 14, within said Safe Operation Area.

In embodiments, such circuit, e.g. 50, may have said transistor thermal behaviour information is represented by at least a current time curve, the boundary curve PMS or the stepped curve SSI, representing a boundary of the transistor Safe Operating Area.

In embodiments, such circuit, e.g. 50, may have said current time curve, the boundary curve PMS or the stepped curve SSI, acquired from a transistor information source, such as a data sheet, and stored in a way accessible to said Safe Operating Area monitoring circuitry, e.g. 60, in particular in a memory or data repository. In embodiments, said current time curve, the boundary curve PMS or the stepped curve SSI, may be calculated.

In embodiments, e.g. with reference to figure 9 and 11, the circuit, e.g., 50 may include that said Safe Operating Area monitoring circuitry, e.g., 60, comprises

- an input node, e.g., 60a, configured to receive a current value proportional to a current, e.g., ID, for instance I$_{sense}$,

flowing through said power transistor, in particular MOSFET, e.g., 14), in particular measured by the circuit 14a,
- an output node, e.g., 60b, configured to emit an output signal, e.g., OUT,

signal processing circuitry, e.g., detector 303, coupled to the input node to receive the current value proportional to a current, e.g., transistor current ID, flowing through said power transistor, e.g., 14, and configured to detect, e.g., again detector 303), given a stepped curve, e.g., stepped curve SSI, which approximates the boundary curve, e.g., PMS, of the SOA, the current level with respect a set of current levels of said stepped curve, e.g., SSI, at a given time, e.g., x, to which said current value proportional to a transistor current, e.g., ID, corresponds,

counter circuitry, e.g., up/down counter 310, coupled to the signal processing circuitry, e.g., 303), the counter circuitry, being configured

when the value proportional to the transistor current, e.g., ID, is detected, e.g., detector 303, comprised between two current levels of said stepped curve, e.g., SSI, at a given time, e.g., x, counting in a first direction, preferably incrementing, at a determined time step, e.g., STEP_x, by said counter 310 so that its output counter value, e.g., CV, reaches a given value, e.g., maximum value Counter_MAX, when the time duration of the transistor current, e.g., ID, level corresponds to the given time, e.g., x,

latch circuitry, e.g., 311, coupled to the counter circuitry, e.g., 310, the latch circuitry, e.g., 311, sensitive to the count value CV of the counter circuitry, e.g., 310, and configured to emit said output signal, e.g., Out, at said output node 60b, latching the power transistor, e.g., 14, in on state (in particular by the switch, specifically AND gate, 13) until the counter output value, e.g., CV, of the counter 310 reaches the maximum value, e.g., Counter_MAX, then latching, e.g., 311, in off state the transistor, e.g., 14.

Also the counter circuitry, e.g., 310, is configured to count in a second count direction, opposite the first count direction, as a result of the detected current level, e.g., IDET, indicating that said transistor current, e.g., ID, fails to reach a reference value, e.g., INOM, ILOW in the specific example, in particular with a constant step, in particular decreasing until its counter value, e.g., CV, reaches zero, said reference value, e.g., INOM, corresponding in particular to a lower current level, e.g., INOM, among the levels of said stepped curve, e.g., SSI).

Also the first and second count directions of the counter circuitry, e.g., 311, include increasing and decreasing, respectively, the count value of the counter circuitry, e.g., 311.

Then, said transistor thermal behaviour information, e.g., 100, like in circuit 55, may be represented by a thermal model, e.g., 100, in particular lumped model, of said power transistor 14 stored in a way accessible to said Safe Operating Area monitoring circuitry, e.g. 70, for instance in a memory or data repository.

Also, such thermal model, e.g., 100,, in particular lumped model, of said power transistor 14 comprises respective input nodes, e.g. 60a, 60c, 60d, receiving the drain source voltage, e.g. VDS, of the power transistor 14, and its measure of the transistor current, ID, performing on them a convolution at a convolution circuitry, , e.g., 203, in particular after ADC conversion, to calculate a dissipated power Pd, bringing such dissipated power Pd as input to each of a plurality of branches, e.g. B1...Bn, which circuitry, comprising circuits 204, 205, 206, 207, 208, is configured to calculate a thermal impedance, $ZTH_i$, of a respective cell $R_iC_i$ of said lumped model 100, a summation of the output of each branch, e.g. B1...Bn, and of a reference temperature (TREF), in particular ambient temperature or temperature of a given point outside the transistor 14, in particular measure by an outside sensor, being performed at a summation circuit, e.g. summation circuit 209, to obtain a value representative of the junction temperature Tj(t) of the transistor 14.

As indicated the solution also covers a system for supplying electrical power to a load 18 via a power transistor 14, in particular a power MOSFET, such the system 10 or the gate driver module 400, the system comprising:

- the circuit for protection, e.g. 50 or 50' or 55, of any of the embodiments, having an input node, such as 60a configured to receive at least a current value proportional to a current, e.g. ID or Isense, flowing in said transistor 14, and said output node 60b coupled to the control terminal of the switch, e. AND gate 23, of the driver circuit 13 and configured to apply thereto said output signal, signal OUT of circuit 60, 60' or signal OUT Out1 of circuit 70 which drives through circuits 75 and 72 the AND gate 13, to reduce the current flowing in the power transistor (14), in particular controlling the transistor operation with respect to its Safe Operating Area on the basis of at least a current value, e.g. $I_{sense}$, proportional to a current (ID) flowing through said power transistor 14.

Also in general the solution also is directed to a method of operating a circuit, 50, 50'; 55, according to any of the embodiments or a system, 10 or 440, as described above, the method comprising:

controlling, by the monitoring circuitry 60; 60'; 70 the transistor 14 operation with respect to its Safe Operating Area (PMS) on the basis of at least a current value, e.g., $I_{sense}$ proportional to a current, ID, flowing through said power transistor 14,
controlling the operation of the power transistor 14, with respect to said Safe Operating Area (PMS) as a function of transistor thermal behaviour information, e.g., PMS, SSI; 100, and said at least a current value proportional to a current ID flowing through said power transistor 14 to control the value of a junction temperature Tj of the transistor (14), in particular with respect to an upper limit TjMAX of said junction temperature Tj, by controlling on and off states of said driver circuit (13) to obtain a given behaviour in time of the junction temperature Tj of the transistor (14) within said Safe Operation Area.

As shown, in the circuit of figure 11 the limit of the junction temperature Tj is set by setting the maximum counter value, e.g. Counter_Max. In the circuit operating with the thermal model, e.g. 70, the drain source voltage is also at least taken in account as input and the junction temperature Tj is estimated in block 70 and then compared to a maximum temperature TjMAX to select the switch on and switch off state of the driver 13 and transistor 14.

From the description above it is thus clear the solution described and its advantages.

The solution described avoids having an integrated thermal sensor inside the Power MOSFET obtained by performing instant junction temperature emulation via transistor current sensing and, optionally, voltage sensing.

The solution described can be integrated in a Power-MOS gate driver module with the aim to protect the transistor, i.e. Power-MOS itself against excessive fast and slow thermal events due to overload conditions. The solution described ensures the safe operation of the Power-MOS and at the same time makes available the full current time operation capability of the Power-MOS itself.

Without prejudice to the underlying principles, the details and embodiments may vary, even significantly, with respect to what has been presented herein by way of example only without departing from the scope of protection.

The extent of protection is defined by the annexed claims.

**Claims**

1.  A circuit (50; 50'; 55) for protection of a power transistor (14), in particular a power MOSFET, coupled at a first electrode to a battery power supply (15) and to another electrode to a load (18), and driven at a driving electrode by a driver circuit (13), wherein

    said circuit for protection (50; 50'; 55) comprises Safe Operating Area monitoring circuitry (60; 60'; 70) configured to control the transistor (14) operation with respect to its Safe Operating Area (PMS), which receives as input at least a current value ($I_{sense}$) proportional to a current (ID) flowing through said power transistor (14),
    said Safe Operating Area monitoring circuitry (60; 60'; 70) being configured to control the operation of the power transistor (14) with respect to said Safe Operating Area (PMS) as a function of transistor thermal behaviour information (PMS, SSI; 100) and said at least a current value proportional to a current (ID) flowing through said power transistor (14) to control the value of a junction temperature (Tj) of the transistor (14), outputting an output signal (OUT; OUT1) which value controls on and off states of said driver circuit (13) by a switch (23) driving of the power transistor to obtain a given behaviour in time of the junction temperature (Tj) of the transistor (14) within said Safe Operation Area.

2.  The circuit (50; 50'; 55) of claim 1, wherein said transistor thermal behaviour information is represented by at least a current time curve (PMS, SSI) representing a boundary of the transistor Safe Operating Area.

3.  The circuit (50; 50'; 55) of claim 1 or claim 2, wherein said current time curve (PMS, SSI) is acquired from a transistor information source and stored in a way accessible to said Safe Operating Area monitoring circuitry (60).

4.  The circuit (50; 50'; 55) of claim 1 or claim 2, wherein said current time curve (PMS, SSI) is calculated.

5.  The circuit (50; 50'; 55) of claim 1 or claim 2, wherein said transistor thermal behaviour information (100) is represented by a thermal model (100), in particular lumped model, of said power transistor (100) stored in a way accessible to said Safe Operating Area monitoring circuitry (70).

6.  The circuit (50; 50'; 55) of claim 1, wherein said Safe Operating Area monitoring circuitry (60) comprises

    - an input node (60a) configured to receive a current value proportional to a current (ID) flowing through said power transistor (14),
    - an output node (60b) configured to emit an output signal (OUT),
    signal processing circuitry (303) coupled to the input node to receive the current value proportional to a current (ID) flowing through said power transistor (14) and configured to detect (303), given a stepped curve (SSI) which approximates the boundary curve (PMS) of the SOA, the current level with respect to a set of current levels of said stepped curve (SSI) at a given time (x) to which said current value proportional to a transistor current (ID) corresponds,

counter circuitry (310) coupled to the signal processing circuitry (303), the counter circuitry (310) being configured when the value proportional to the transistor current (ID) is detected (303) comprised between two current levels of said stepped curve (SSI) at a given time (x), counting in a first direction a determined time step (STEP_x) said counter so that its output counter value (CV) reaches a given value (Counter_MAX), when the time duration of the transistor current (ID) level corresponds to the given time (x),

latch circuitry (311) coupled to the counter circuitry (310), the latch circuitry (311) sensitive to the count value of the counter circuitry (310) and configured to emit said output signal (Out) at said output node, latching the power transistor (14) in on state until the counter output value (CV) of the counter 310 reaches the maximum value (Counter_MAX), then latching (311) in off state the transistor (14).

7. The circuit (50; 50'; 55) of claim 1 or claim 2, wherein the counter circuitry (310) is configured to count in a second count direction, opposite the first count direction, as a result of the detected current level (IDET) indicating that said transistor current (ID) fails to reach a reference value (INOM), in particular with a constant step, in particular decreasing until its counter value (CV) reaches zero, said reference value (INOM) corresponding in particular to a lower current level (INOM) among the levels of said stepped curve (SSI).

8. The circuit (50; 50'; 55) of claim 6 or 7, wherein:

- the first and second count directions of the counter circuitry (311) include increasing and decreasing, respectively, the count value of the counter circuitry (311).

9. The circuit (50; 50'; 55) of claim 5, wherein said thermal model (100), in particular lumped model, of said power transistor (100) stored in a way accessible to said Safe Operating Area monitoring circuitry (70) comprises respective input nodes (60a, 60c, 60d) receiving the drain source voltage (VDS) of the power transistor 14, and its measure of the transistor current (ID), performing on them a convolution at a convolution circuitry (203) to calculate a dissipated power (Pd), bringing said dissipated power (Pd) as input to each of a plurality of branches (B1...Bn) which circuitry (204, 205, 206, 207, 208) is configured to calculate a thermal impedance $(ZTH_i)$ of a respective cell $(R_iC_i)$ of said lumped model (100), obtaining respective circuits, a summation of the output of each branch and of a reference temperature (TREF), in particular ambient temperature or temperature of a given point outside the transistor (14), being performed at a summation circuit (209) to obtain a value representative of the junction temperature (Tj(t)) of the transistor (14).

10. A system (10) for supplying electrical power to a load (18) via a power transistor 14, in particular a power MOSFET, the system comprising:

- the circuit (50; 50'; 55) of any of claims 1 to 9, the circuit (50; 50'; 55) having an input node (60a) configured to receive at least a current value proportional to a current (ID) flowing in said transistor (14), and said output node (60b) coupled (180) to the control terminal of the switch (23) of the driver circuit (13) and configured to apply thereto said output signal (Out; Out1) to reduce the current flowing in the power transistor (14).

11. A method of operating a circuit (50, 50'; 55) according to any of claims 1 to 9 or a system (10) according to claim 10, the method comprising:

controlling (60; 60'; 70 the transistor (14) operation with respect to its Safe Operating Area (PMS) on the basis of at least a current value $(I_{sense})$ proportional to a current (ID) flowing through said power transistor (14),

controlling the operation of the power transistor (14) with respect to said Safe Operating Area (PMS) as a function of transistor thermal behaviour information (PMS, SSI; 100) and said at least a current value proportional to a current (ID) flowing through said power transistor (14) to control the value of a junction temperature (Tj) of the transistor (14), in particular with respect to an upper limit (TjMAX) of said junction temperature (Tj), by controlling on and off states of said driver circuit (13) to obtain a given behaviour in time of the junction temperature (Tj) of the transistor (14) within said Safe Operation Area.

Fig. 1

Fig. 2

EP 4 718 723 A1

Fig. 3

Fig. 4

EP 4 718 723 A1

Fig. 5

Fig. 6

Fig. 8

Fig. 7

Fig. 9

Fig. 10

EP 4 718 723 A1

Fig. 11

**Fig. 12**

EP 4 718 723 A1

Fig. 13

Fig. 14

Fig. 15

EP 4 718 723 A1

Fig. 16

Fig. 17

Fig. 18

REF

115

114

113

111b
112
111a

110

TREF(t)

Ta

Tj

EP 4 718 723 A1

## Fig. 19

SREF

115

113

111b

112

114

13

Gate Driver

111a

110

Tj

Ta

TREF(t)

Fig. 20

| | Europäisches Patentamt European Patent Office Office européen des brevets | **EUROPEAN SEARCH REPORT** | **Application Number** EP 25 30 6490 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | BAUMANN MARTIN ET AL: "Resource-Saving Modeling of an Electronic Fuse in Vehicular Power Systems", 2023 IEEE VEHICLE POWER AND PROPULSION CONFERENCE (VPPC), IEEE, 24 October 2023 (2023-10-24), pages 1-6, XP034532387, DOI: 10.1109/VPPC60535.2023.10403182 | 1-5,9-11 | INV. H03K17/082 ADD. H03K17/08 |
| A | * I. MOTIVATION AND RELATED WORK II. TRIGGERING MECHANISIMS OF ELECTRONIC FUSES III. ABSTRACTED ELECTRONIC FUSE MODEL IV. VERIFICATION; figures 1,2,3,5,10; table 1 * ----- | 6-8 | |
| X | FOUNTOUKIDIS SYMEON ET AL: "Digital Implementation of I2t Protection Scheme by means of Solid-State Devices", 2023 12TH INTERNATIONAL CONFERENCE ON MODERN CIRCUITS AND SYSTEMS TECHNOLOGIES (MOCAST), IEEE, 28 June 2023 (2023-06-28), pages 1-5, XP034378874, DOI: 10.1109/MOCAST57943.2023.10177016 | 1-4,6-8, 10,11 | |
| A | * I.INTRODUCTION II SSCB OPERATION ANALYSIS III. SIMULATION AND EXPERIOMENTAL VALIDATION OF THE I2T CONTROL LOOP IV. EXPERIMNETAL VALIDATION OF THE I2T CONTROL LOOP; figures 2,3,5,6,8,9 * ----- | 5,9 | TECHNICAL FIELDS SEARCHED (IPC) H03K |
| X | US 2006/221527 A1 (JACOBSON BORIS S [US]) 5 October 2006 (2006-10-05) | 1-5,9-11 | |
| A | * paragraph [0093] - paragraph [0101]; figures 7,8,9,10,13,14 * * paragraph [0116] - paragraph [0120] * ----- -/-- | 6-8 | |

The present search report has been drawn up for all claims

| Place of search | Date of completion of the search | Examiner |
|---|---|---|
| The Hague | 15 January 2026 | O'Reilly, Siobhan |

EPO FORM 1503 03.82 (P04C01)

**page 1 of 2**

Europäisches
Patentamt

European
Patent Office

Office européen
des brevets

**EUROPEAN SEARCH REPORT**

Application Number

EP 25 30 6490

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 299 767 B1 (TUOZZOLO CLAUDIO [US] ET AL) 30 October 2012 (2012-10-30) | 1,10,11 | |
| A | * column 7, line 52 - line 67; figures 9,11,14,16,17,22 *<br>* column 8, line 1 - line 48 *<br>----- | 2-9 | |
| A | SINTAMAREAN C ET AL: "A novel electro-thermal model for wide bandgap semiconductor based devices",<br>2013 15TH EUROPEAN CONFERENCE ON POWER ELECTRONICS AND APPLICATIONS (EPE), IEEE, 2 September 2013 (2013-09-02), pages 1-10, XP032505367,<br>DOI: 10.1109/EPE.2013.6631982<br>* figures 1,4,5 *<br>----- | 1-11 | |

TECHNICAL FIELDS
SEARCHED (IPC)

The present search report has been drawn up for all claims

| Place of search | Date of completion of the search | Examiner |
|---|---|---|
| The Hague | 15 January 2026 | O'Reilly, Siobhan |

EPO FORM 1503 03.82 (P04C01)

page 2 of 2

## ANNEX TO THE EUROPEAN SEARCH REPORT
## ON EUROPEAN PATENT APPLICATION NO.

EP 25 30 6490

This annex lists the patent family members relating to the patent documents cited in the above-mentioned European search report.
The members are as contained in the European Patent Office EDP file on
The European Patent Office is in no way liable for these particulars which are merely given for the purpose of information.

15-01-2026

| Patent document cited in search report | | Publication date | Patent family member(s) | | Publication date |
|---|---|---|---|---|---|
| US 2006221527 | A1 | 05-10-2006 | AU | 2006232963 A1 | 12-10-2006 |
| | | | BR | PI0607705 A2 | 05-10-2010 |
| | | | CA | 2598485 A1 | 12-10-2006 |
| | | | CN | 101167251 A | 23-04-2008 |
| | | | EP | 1867046 A2 | 19-12-2007 |
| | | | EP | 2270983 A1 | 05-01-2011 |
| | | | IL | 184796 A | 27-09-2011 |
| | | | JP | 6282169 B2 | 21-02-2018 |
| | | | JP | 2008535255 A | 28-08-2008 |
| | | | JP | 2014197684 A | 16-10-2014 |
| | | | KR | 20080002843 A | 04-01-2008 |
| | | | KR | 20120034760 A | 12-04-2012 |
| | | | TW | I392230 B | 01-04-2013 |
| | | | US | 2006221527 A1 | 05-10-2006 |
| | | | US | 2011050324 A1 | 03-03-2011 |
| | | | WO | 2006107579 A2 | 12-10-2006 |
| US 8299767 | B1 | 30-10-2012 | NONE | | |

EPO FORM P0459

For more details about this annex : see Official Journal of the European Patent Office, No. 12/82